# EUROPEAN PATENT SPECIFICATION

(11) **EP 3 396 015 B1**
(45) Date of publication and mention of the grant of the patent: **21.04.2021**
(21) Application number: 16894155.7
(22) Date of filing: 21.09.2016
(51) Int. Cl.: C23C 14/34, C23C 14/08, C23C 14/06, C23C 14/00, C23C 14/02, C23C 28/00

(54) **COMPOSITE FUNCTIONAL CUTTER COATING FOR CUTTING TITANIUM ALLOY AND PREPARATION METHOD THEREFOR**
FUNKTIONALE KOMPOSITSCHNEIDERBESCHICHTUNG ZUM SCHNEIDEN VON TITANLEGIERUNG UND HERSTELLUNGSVERFAHREN DAFÜR
REVÊTEMENT COMPOSITE D'OUTIL DE COUPE FONCTIONNEL POUR COUPER UN ALLIAGE DE TITANE ET SON PROCÉDÉ DE FABRICATION

(30) Priority: 18.03.2016 CN 201610165058
(43) Date of publication of application: 31.10.2018
(73) Proprietor: Northeastern University, Shenyang, Liaoning 110819 (CN)
(72) Inventor: LI, Guojian, Shenyang Liaoning 110819 (CN); SUI, Xudong, Shenyang Liaoning 110819 (CN); JIANG, Chenjie, Shenyang Liaoning 110819 (CN); WANG, Kai, Shenyang Liaoning 110819 (CN); WANG, Qiang, Shenyang Liaoning 110819 (CN)
(74) Representative: Office Kirkpatrick
(86) International application number: PCT/CN2016/099574
(87) International publication number: WO 2017/156996

(56) References cited:
- EP-A1- 1 722 009
- EP-A2- 1 201 776
- EP-A2- 2 072 636
- CN-A- 1 853 832
- CN-A- 103 586 520
- CN-A- 104 508 185
- CN-A- 104 975 259
- CN-A- 105 734 505
- JP-A- 2006 224 198
- JP-A- 2007 105 841
- US-A1- 2006 246 320
- VISHAL KHETAN ET AL: "Temperature-Dependent Wear Mechanisms for Magnetron-Sputtered AlTiTaN Hard Coatings", ACS APPLIED MATERIALS & INTERFACES, vol. 6, no. 17, 10 September 2014 (2014-09-10), pages 15403-15411, XP055610265, US ISSN: 1944-8244, DOI: 10.1021/am503942x
- TKADLETZ MICHAEL ET AL: "Advanced characterization methods for wear resistant hard coatings: A review on recent progress", SURFACE AND COATINGS TECHNOLOGY, vol. 285, 14 November 2015 (2015-11-14), pages 31-46, XP029364838, ISSN: 0257-8972, DOI: 10.1016/J.SURFCOAT.2015.11.016
- CHIA-HAN LAI ET AL: "Effect of substrate bias on the structure and properties of multi-element (AlCrTaTiZr)N coatings; Substrate bias on the structure and properties of (AlCrTaTiZr)N coatings", JOURNAL OF PHYSICS D: APPLIED PHYSICS, INSTITUTE OF PHYSICS PUBLISHING LTD, GB, vol. 39, no. 21, 7 November 2006 (2006-11-07), pages 4628-4633, XP020094868, ISSN: 0022-3727, DOI: 10.1088/0022-3727/39/21/019

## Description

### Technical Field

The present invention belongs to the technical field of cutting tool protection coatings for cutting hardworking materials, and particularly relates to a composite functional cutting tool coating for cutting titanium alloys, and a preparation method thereof.

### Background Art

Titanium alloys are high-strength lightweight materials with good heat resistance and corrosion resistance, and are widely applied to fields such as aviation, aerospace, automobiles, chemistry and biology. Especially in the aerospace field, titanium alloys are increasingly applied year by year. When aircraft components are manufactured from titanium alloys, not only can the service life of aircrafts be prolonged, but also the weight and fuel consumption can be reduced, so that the flight performance can be greatly improved.

However, the machinability of the titanium alloys is very poor due to excellent properties, wherein low thermal conductivity, high chemical reactivity and low modulus of elasticity of the titanium alloys are main causes for machining difficulty of the titanium alloys. Particularly, the titanium alloy materials are high in chemical activity, the titanium alloys can become extremely active especially at 500 DEG C or above and can cause a chemical reaction with cutting tool materials, so that severe cutting tool sticking can be caused, further the wear of the cutting tools is serious, and the service life of the cutting tools is shortened.

Currently, cutting tool materials for cutting titanium alloys at home and abroad mainly include coated and uncoated cemented carbide, cubic boron nitride, polycrystalline diamond, and the like., wherein the cubic boron nitride and the polycrystalline diamond cutting tools limit the application of the cutting tools in cutting of the titanium alloys due to over high price; the uncoated cemented carbide cutting tools have favorable cutting performance when being used for cutting the titanium alloys at low speed but have unsatisfactory cutting effects at high speed; the coated cemented carbide cutting tools have good hardness and toughness of a base body, and besides, one or more wear-resistant, high-temperature-resistant and oxidation-resistant coatings are applied to the surfaces, so that titanium alloys can be effectively cut and the application scope is the widest. Such coated tools are for example disclosed in JP200710841 where a (Ti, Al, Ta)N layer is coated on the cemented carbide tool. 20 to 35 mol% Ta is necessary to efficiently reduce the reactivity of the coated at high operational temperatures. EP1722009 discloses alternative coatings, comprising a layer of h-MeX combined with an additional layer of carbide, nitride of oxide. However, current commercial cutting tool coatings (such as TiCN, TiAlN and TiAlSiN) for cutting titanium alloys can easily have a sticking reaction with titanium and its alloys thereof during cutting, which will cause serious sticking of the cutting tool and form built-up edges at the cutting interface. The built-up edges can leave the tool body during follow-up cutting and take away part of the tool materials to enable the cutting tool to be abraded increasingly. In conclusion, a cutting tool coating which has low sticking reactivity with titanium alloys needs to be developed so as to reduce cutting tool sticking in cutting of titanium and alloys thereof, reduce the wear of the cutting tools, and extend the service life of the cutting tools.

### Summary of Invention

In order to solve the technical problems, the prevent invention provides a composite functional cutting tool coating for cutting titanium alloys, and a preparation method thereof. The prepared cutting tool coating disclosed by the present invention can effectively reduce the sticking phenomenon between the coating and workpiece materials during cutting of titanium alloys and can effectively prolong the service life of coated cutting tools, and the prepared cutting tool coating is very suitable for machining of titanium and alloys thereof.

A composite functional cutting tool coating for cutting titanium alloys comprises a bottom coating and a top coating, wherein
the bottom coating consists of the following elements in atomic percentage: 10-40at.% of titanium, 5-20at.% of aluminum, 2-18at.% of tantalum and 40.16-55at.% of nitrogen, and the thickness is 1 to 4 micrometers; and the top coating consists of the following elements in atomic percentage: 50-78.02at.% of oxygen, 8-35at.% of tantalum, and the thickness is 50-1500 nm.

A preparation method of the composite functional cutting tool coating for cutting titanium alloys comprises the following steps of
Step 1: performing pretreatment on a cutting tool base body:
   performing wet-sand blasting on the cutting tool base body, performing cleaning, performing drying at 80-150 DEG C for 5-15 min, and placing the dried cutting tool base body into a vacuum chamber;
Step 2: performing glow sputter cleaning on the cutting tool base body:
   when the vacuum degree of the vacuum chamber is better than or equal to 3×10⁻³ Pa, performing warming to 350-500 DEG C, introducing high-purity Ar gas into the vacuum chamber, adjusting the pressure intensity of the vacuum chamber to 0.5-2 Pa, and performing glow sputter cleaning for 15-30 min under the condition that pulsed negative bias is 500-1000 V and the duty cycle is 20-80%;
Step 3: preparing the bottom coating:
   under the deposition condition that N₂ gas with flow of 20-50sccm is introduced into the vacuum chamber, besides the flow of Ar gas is adjusted to 30-50sccm, the temperature is 400-500 DEG C, the negative bias is 20-180 V, and the vacuum degree is 0.3-0.9 Pa,
   depositing a pure Ti transition layer of which the thickness is 150-300 nm with a pure titanium target with purity of 99.99%;
   with the deposition condition unchanged, preparing the bottom coating by the method (1) or method (2):
      (1) depositing a bottom coating of which the thickness is 1 to 4 micrometers with a titanium-aluminum-tantalum alloy target; and
      (2) preparing a bottom coating of which the thickness is 1 to 4 micrometers by the method of co-sputtering with a titanium-aluminum alloy target and a pure tantalum target;
Step 4: preparing the top coating:
   after preparation of the bottom coating, closing N₂ gas, introducing high-purity O₂ gas with flow of 15-50sccm into the vacuum chamber, and with vacuum degree and negative bias unchanged, depositing a top coating of which the thickness is 50-1500 nm with a pure tantalum target; and
Step 5: lowering the temperature to 120 DEG C along with the furnace, then taking out the cutting tool, and performing cooling at normal temperature.

In the step 1, blasting sand for wet-sand blasting treatment comprises the following components in percentage by mass: 20-35% of alumina abrasives with particle size of 400-600 meshes, 1-15% of an antirust agent and 50-79% of water; the sand blasting pressure is 0.5-0.8 MPa, and the sand blasting time is 10-20 min; the cleaning process for the cutting tool base body is as follows: firstly, cleaning the cutting tool base body with a commercial finished cleaning agent for 5 min or above, and then, cleaning the cutting tool base body with clean water for 5 min or above.

In the method (1) of the step 3, the titanium-aluminum-tantalum alloy target comprises the following components in atomic percentage: 20-70at.% of titanium, 5-50at.% of aluminum and 5-35at.% of tantalum; in the method (2) of the step 3, the titanium-aluminum alloy target comprises the following components in atomic percentage: 20-80at.% of titanium and 20-80at.% of aluminum. A composite functional cutting tool coating and a preparation method of such coating according to the invention are defined in the appended claims.

Compared with the prior art, the composite functional cutting tool coating for cutting the titanium alloys, and the preparation method thereof, disclosed by the present invention have the following beneficial effects that:
1. the present invention provides the composite functional cutting tool coating which can reduce sticking between the cutting tool material and workpieces when a titanium alloy material is cut, and a preparation method thereof. The prepared coated cutting tool can effectively reduce the sticking phenomenon between the coating and workpiece materials during cutting of titanium alloys and can effectively prolong the service life of coated cutting tools, and the prepared cutting tool coating is very suitable for machining of titanium and alloys thereof.
2. According to the the composite functional cutting tool coating for cutting titanium alloys, and the preparation method thereof disclosed by the prevent invention, the prepared coating comprises a bottom coating with high hardness and oxidation resistance and a TaO functional coating with small reactivity with titanium and alloys thereof, wherein the bottom coating not only can be a single-layer uniform coating but also can be a gradient coating; the functional coating not only can be deposited on the bottom coating, but also can be deposited on other wear-resistant cutting tool coatings, and can achieve the effects of reducing sticking phenomenon and wear and prolonging the service life of the cutting tools under both conditions.
3. According to the composite functional cutting tool coating for cutting titanium alloys, and the preparation method thereof disclosed by the prevent invention, the composite functional cutting tool coating is deposited on a cutting tool base after a cutting tool is pretreated. The coated cutting tool prepared by the method has good matching properties between the base material and the composite functional cutting tool coating, so that the coating has the characteristics of being high in wear resistance, excellent in oxidation resistance and low in stickiness with titanium and alloys thereof; titanium alloy cutting experiment proves that the prepared composite functional cutting tool coating disclosed by the present invention can obviously reduce sticking between the coated cutting tool and workpiece materials, reduce the wear of the coated cutting tool and prolong the service life of the coated cutting tool.
4. The composite functional cutting tool coating for cutting titanium alloys, and the preparation method thereof disclosed by the prevent invention are easy to implement, low in coat and good in effects.

### Description of the Drawings

Fig.1 is the schematic cross section of the composite functional cutting tool coating prepared in the embodiment of the present invention, wherein 1-cutting tool base body, 2-bottom coating, and 3-oxide functional layer;
Fig.2 is the relationship diagram between the tool flank wear and the cutting length of the cutting tool with the TiAlTaN/TaO composite functional cutting tool coating prepared in the embodiment 8 of the present invention and the cutting tool with the single-layer TiAlTaN coating prepared in the comparison example 1;

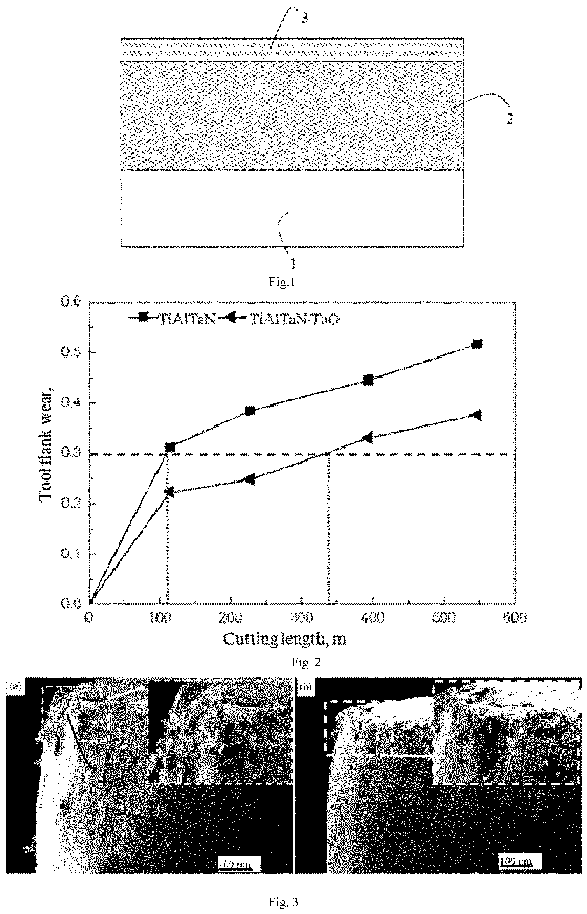

Fig.3 is the wear appearance photos of the cutting tool with the TiAlTaN/TaO composite functional cutting tool coating prepared in the embodiment 8 of the present invention and the cutting tool with the single-layer TiAlTaN coating prepared in the comparison example 1, wherein (a) is the wear appearance photo of the cutting tool with the single-layer TiAlTaN coating prepared in the comparison example 1, and (b) is the wear appearance photo of the cutting tool with the TiAlTaN/TaO composite functional cutting tool coating prepared in the embodiment 8, 4-sticking substance, and 5-cutting material falling part;
Fig.4 is the frictional wear experiment curve of the cutting tool with the TiAlTaN/TaO composite functional cutting tool coating prepared in the embodiment 8 of the present invention and the cutting tool with the single-layer TiAlTaN coating prepared in the comparison example 1; and
Fig.5 is the tool flank wear bar charts of the cutting tool with the TiAlSiN/TaO composite functional cutting tool coating prepared in the comparison example 2 of the present invention and the cutting tool with the TiAlSiN coating prepared in the comparison example 3.

### Detailed Description

The embodiments will now be further described in connection with the accompanying drawings.

### Embodiment 1

A composite functional cutting tool coating for cutting titanium alloys comprises a bottom coating and a top coating, wherein
the bottom coating comprises the following elements in atomic percentage: 30.01at.% of titanium, 20at.% of aluminum, 4.43at.% of tantalum and 45.56at.% of nitrogen, and the thickness is 2.7 micrometers ; and the top coating comprises the following elements in atomic percentage: 71.02at.% of oxygen, 28.98at.% of tantalum and the thickness is 150 nm.

A preparation method of the composite functional cutting tool coating for cutting titanium alloys comprises the following steps of
Step 1: performing pretreatment on a cutting tool base body:
   performing wet-sand blasting on the cutting tool base body, after cleaning, performing drying at 150 DEG C for 15 min, and placing the dried cutting tool base body into a vacuum chamber, wherein blasting sand for wet-sand blasting treatment comprises the following components in percentage by mass: 32% of alumina abrasives with particle size of 600 meshes, 2% of an antirust agent and 66% of water; the sand blasting pressure is 0.5 MPa, and the sand blasting time is 20 min; the cleaning process for the cutting tool base body is as follows: firstly, cleaning the cutting tool base body with a commercial finished cleaning agent for 10min, and then, cleaning the cutting tool base body with clean water for 5 min;
Step 2: performing glow sputter cleaning on the cutting tool base body:
   when the vacuum degree of the vacuum chamber is greater than or equal to 3×10⁻³ Pa, performing warming to 500 DEG C, introducing high-purity Ar gas into the vacuum chamber, adjusting the pressure intensity of the vacuum chamber to 2 Pa, and performing glow sputter cleaning for 30 min under the condition that pulsed negative bias is 1000 V and the duty cycle is 20%;
Step 3: preparing the bottom coating:
   under the deposition condition that N₂ gas with flow of 25sccm is introduced into the vacuum chamber, besides the flow of Ar gas is adjusted to 50sccm, the temperature is 400 DEG C, the negative bias is 180 V, and the vacuum degree is 0.6 Pa,
   depositing a pure Ti transition layer of which the thickness is 300 nm with a pure titanium target with purity of 99.99%; and
   with the deposition condition unchanged, depositing a bottom coating of which the thickness is 2.7[mu]m with a titanium-aluminum-tantalum alloy target, wherein the titanium-aluminum-tantalum alloy target comprises the following components in atomic percentage of 56at.% of titanium, 36at.% of aluminum and 8at.% of tantalum;
Step 4: preparing the top coating:
   after preparation of the bottom coating, closing N₂ gas, introducing high-purity O₂ gas with flow of 42sccm into the vacuum chamber, and with vacuum degree and negative bias unchanged, depositing a top coating of which the thickness is 150 nm with pure tantalum target; and
Step 5: lowering the temperature to 120 DEG C along with the furnace, then taking out the cutting tool, and performing cooling at normal temperature.

The structure of the prepared composite functional cutting tool coating for cutting titanium alloys is shown as fig.1.

### Embodiment 2

A composite functional cutting tool coating for cutting titanium alloys comprises a bottom coating and a top coating, wherein
the bottom coating comprises the following elements in atomic percentage: 30.01at.% of titanium, 19.12at.% of aluminum, 4.31at.% of tantalum and 46.56at.% of nitrogen, and the thickness is 2.7 micrometers ; and the top coating comprises the following elements in atomic percentage:70.02at.% of oxygen, 29.98at.% of tantalum and the thickness is 300nm.

A preparation method of the composite functional cutting tool coating for cutting titanium alloys comprises the following steps of
Step 1: performing pretreatment on a cutting tool base body:
   performing wet-sand blasting on the cutting tool base body, after cleaning, performing drying at 150 DEG C for 15 min, and placing the dried cutting tool base body into a vacuum chamber, wherein blasting sand for wet-sand blasting treatment comprises the following components in percentage by mass: 20% of alumina abrasives with particle size of 400 meshes, 15% of an antirust agent and 65% of water, the sand blasting pressure is 0.8 MPa, and the sand blasting time is 20min; the cleaning process for the cutting tool base body is as follows: firstly, cleaning the cutting tool base body with a commercial finished cleaning agent for 10min, and then, cleaning the cutting tool base body with clean water for 5 min;
Step 2: performing glow sputter cleaning on the cutting tool base body:
   when the vacuum degree of the vacuum chamber is greater than or equal to 3×10⁻³ Pa, performing warming to 500 DEG C, introducing high-purity Ar gas into the vacuum chamber, adjusting the pressure intensity of the vacuum chamber to 2Pa, and performing glow sputter cleaning for 30min under the condition that pulsed negative bias is 1000 V and the duty cycle is 50%;
Step 3: preparing the bottom coating:
   under the deposition condition that N₂ gas with flow of 30sccm is introduced into the vacuum chamber, besides the flow of Ar gas is adjusted to 50sccm, the temperature is 400 DEG C, the negative bias is 180 V, and the vacuum degree is 0.65Pa, depositing a pure Ti transition layer of which the thickness is 300nm with a pure titanium target with purity of 99.99%; and
   with the deposition condition unchanged, depositing a bottom coating of which the thickness is 2.7 micrometers with a titanium-aluminum-tantalum alloy target, wherein the titanium-aluminum-tantalum alloy target comprises the following components in atomic percentage of 70at.% of titanium, 5at.% of aluminum and 25at.% of tantalum;
Step 4: preparing the top coating:
   after preparation of the bottom coating, closing N₂ gas, introducing high-purity O₂ gas with flow of 42sccm into the vacuum chamber, and with vacuum degree and negative bias unchanged, depositing a top coating of which the thickness is 300nm with a pure tantalum target; and
Step 5: lowering the temperature to 120 DEG C along with the furnace, then taking out the cutting tool, and performing cooling at normal temperature.

The structure of the prepared composite functional cutting tool coating for cutting titanium alloys is shown as fig.1.

### Embodiment 3

A composite functional cutting tool coating for cutting titanium alloys comprises a bottom coating and a top coating, wherein
the bottom coating comprises the following elements in atomic percentage: 14.39at.% of titanium, 15.12at.% of aluminum, and 18at.% of tantalum and 52.49at.% of nitrogen, and the thickness is 4 micrometers ; and the top coating comprises the following elements in atomic percentage: 50at.% of oxygen, 50at.% of tantalum and the thickness is 150 nm.

A preparation method of the composite functional cutting tool coating for cutting titanium alloys comprises the following steps of
Step 1: performing pretreatment on a cutting tool base body:
   performing wet-sand blasting on the cutting tool base body, after cleaning, performing drying at 150 DEG C for 15 min, and placing the dried cutting tool base body into a vacuum chamber, wherein blasting sand for wet-sand blasting treatment comprises the following components in percentage by mass: 35% of alumina abrasives with particle size of 600 meshes, 1% of an antirust agent and 64% of water; the sand blasting pressure is 0.5 MPa, and the sand blasting time is 20 min; the cleaning process for the cutting tool base body is as follows: firstly, cleaning the cutting tool base body with a commercial finished cleaning agent for 5min, and then, cleaning the cutting tool base body with clean water for 5 min;
Step 2: performing glow sputter cleaning on the cutting tool base body:
   when the vacuum degree of the vacuum chamber is greater than or equal to 3×10⁻³ Pa, performing warming to 500 DEG C, introducing high-purity Ar gas into the vacuum chamber, adjusting the pressure intensity of the vacuum chamber to 2 Pa, and performing glow sputter cleaning for 30 min under the condition that pulsed negative bias is 1000 V and the duty cycle is 20%;
Step 3: preparing the bottom coating:
   under the deposition condition that N₂ gas with flow of 25sccm is introduced into the vacuum chamber, besides the flow of Ar gas is adjusted to 50sccm, the temperature is 400 DEG C, the negative bias is 180 V, and the vacuum degree is 0.6 Pa,
   depositing a pure Ti transition layer of which the thickness is 300 nm with a pure titanium target with purity of 99.99%; and
   with the deposition condition unchanged, depositing a bottom coating of which the thickness is 4 micrometers by the method of co-sputtering with a titanium-aluminum alloy target and a pure tantalum target, wherein the titanium-aluminum-tantalum alloy target comprises the following components in atomic percentage of 50at.% of titanium, and 50at.% of aluminum;
Step 4: preparing the top coating:
   after preparation of the bottom coating, closing N₂ gas, introducing high-purity O₂ gas with flow of 15sccm into the vacuum chamber, and with vacuum degree and negative bias unchanged, depositing a top coating of which the thickness is 150 nm with a pure tantalum target; and
Step 5: lowering the temperature to 120 DEG C along with the furnace, then taking out the cutting tool, and performing cooling at normal temperature.

The structure of the prepared composite functional cutting tool coating for cutting titanium alloys is shown as fig.1.

### Embodiment 4

A composite functional cutting tool coating for cutting titanium alloys comprises a bottom coating and a top coating, wherein
the bottom coating comprises the following elements in atomic percentage: 39.92at.% of titanium, 6.12at.% of aluminum, 13.8at.% of tantalum and 40.16at.% of nitrogen, and the thickness is 1 micrometer ; and the top coating comprises the following elements in atomic percentage: 78.02at.% of oxygen, 21.98at.% of tantalum and the thickness is 1000 nm.

A preparation method of the composite functional cutting tool coating for cutting titanium alloys comprises the following steps of
Step 1: performing pretreatment on a cutting tool base body:
   performing wet-sand blasting on the cutting tool base body, after cleaning, performing drying at 80 DEG C for 10min, and placing the dried cutting tool base body into a vacuum chamber, wherein blasting sand for wet-sand blasting treatment comprises the following components in percentage by mass: 20% of alumina abrasives with particle size of 400 meshes, 1% of an antirust agent and 79% of water; the sand blasting pressure is 0.8 MPa, and the sand blasting time is 10min; the cleaning process for the cutting tool base body is as follows: firstly, cleaning the cutting tool base body with a commercial finished cleaning agent for 10min, and then, cleaning the cutting tool base body with clean water for 5 min;
Step 2: performing glow sputter cleaning on the cutting tool base body:
   when the vacuum degree of the vacuum chamber is greater than or equal to 3×10⁻³ Pa, performing warming to 350 DEG C, introducing high-purity Ar gas into the vacuum chamber, adjusting the pressure intensity of the vacuum chamber to 0.5 Pa, and performing glow sputter cleaning for 15min under the condition that pulsed negative bias is 500 V and the duty cycle is 80%;
Step 3: preparing the bottom coating:
   under the deposition condition that N₂ gas with flow of 50sccm is introduced into the vacuum chamber, besides the flow of Ar gas is adjusted to 50sccm, the temperature is 400 DEG C, the negative bias is 180 V, and the vacuum degree is 0.9 Pa,
   depositing a pure Ti transition layer of which the thickness is 150 nm with a pure titanium target with purity of 99.99%; and
   with the deposition condition unchanged, depositing a bottom coating of which the thickness is 1 micrometer by the method of co-sputtering with a titanium-aluminum alloy target and a pure tantalum target, wherein the titanium-aluminum-tantalum alloy target comprises the following components in atomic percentage of 20at.% of titanium, and 80at.% of aluminum;
Step 4: preparing the top coating:
   after preparation of the bottom coating, closing N₂ gas, introducing high-purity O₂ gas with flow of 50sccm into the vacuum chamber, and with vacuum degree and negative bias unchanged, depositing a top coating of which the thickness is 1000 nm with a pure tantalum target; and
Step 5: lowering the temperature to 120 DEG C along with the furnace, then taking out the cutting tool, and performing cooling at normal temperature.

The structure of the prepared composite functional cutting tool coating for cutting titanium alloys is shown as fig.1.

### Embodiment 5

A composite functional cutting tool coating for cutting titanium alloys comprises a bottom coating and a top coating, wherein
the bottom coating comprises the following elements in atomic percentage: 23at.% of titanium, 20at.% of aluminum, 2at.% of tantalum and 55at.% of nitrogen, and the thickness is 4 micrometers ; and the top coating comprises the following elements in atomic percentage: 55.01at.% of oxygen, 44.99at.% of tantalum, 2.02at.% of aluminum and 2.19at.% of titanium, and the thickness is 50 nm.

A preparation method of the composite functional cutting tool coating for cutting titanium alloys comprises the following steps of
Step 1: performing pretreatment on a cutting tool base body:
   performing wet-sand blasting on the cutting tool base body, after cleaning, performing drying at 80 DEG C for 15 min, and placing the dried cutting tool base body into a vacuum chamber, wherein blasting sand for wet-sand blasting treatment comprises the following components in percentage by mass: 35% of alumina abrasives with particle size of 600 meshes, 15% of an antirust agent and 50% of water; the sand blasting pressure is 0.5 MPa, and the sand blasting time is 20min; the cleaning process for the cutting tool base body is as follows: firstly, cleaning the cutting tool base body with a commercial finished cleaning agent for 20min, and then, cleaning the cutting tool base body with clean water for 5 min;
Step 2: performing glow sputter cleaning on the cutting tool base body:
   when the vacuum degree of the vacuum chamber is greater than or equal to 3×10⁻³ Pa, performing warming to 500 DEG C, introducing high-purity Ar gas into the vacuum chamber, adjusting the pressure intensity of the vacuum chamber to 0.5 Pa, and performing glow sputter cleaning for 15min under the condition that pulsed negative bias is 500V and the duty cycle is 80%;
Step 3: preparing the bottom coating:
   under the deposition condition that N₂ gas with flow of 25sccm is introduced into the vacuum chamber, besides the flow of Ar gas is adjusted to 50sccm, the temperature is 400 DEG C, the negative bias is 180 V, and the vacuum degree is 0.6 Pa,
   depositing a pure Ti transition layer of which the thickness is 300 nm with a pure titanium target with purity of 99.99%; and
   with the deposition condition unchanged, depositing a bottom coating of which the thickness is 4[mu]m with a titanium-aluminum-tantalum alloy target, wherein the titanium-aluminum-tantalum alloy target comprises the following components in atomic percentage of 50at.% of titanium, 45at.% of aluminum and 5at.% of tantalum;
Step 4: preparing the top coating:
   after preparation of the bottom coating, closing N₂ gas, introducing high-purity O₂ gas with flow of 36sccm into the vacuum chamber, and with vacuum degree and negative bias unchanged, depositing a top coating of which the thickness is 50 nm with a pure tantalum target; and
Step 5: lowering the temperature to 120 DEG C along with the furnace, then taking out the cutting tool, and performing cooling at normal temperature.

The structure of the prepared composite functional cutting tool coating for cutting titanium alloys is shown as fig.1.

### Embodiment 6

A composite functional cutting tool coating for cutting titanium alloys comprises a bottom coating and a top coating, wherein
the bottom coating comprises the following elements in atomic percentage: 10at.% of titanium, 20at.% of aluminum, 15.22at.% of tantalum and 54.78at.% of nitrogen, and the thickness is 3 micrometers; and the top coating comprises the following elements in atomic percentage: 55.01at.% of oxygen, 44.99at.% of tantalum and the thickness is 50 nm.

A preparation method of the composite functional cutting tool coating for cutting titanium alloys comprises the following steps of
Step 1: performing pretreatment on a cutting tool base body:
   performing wet-sand blasting on the cutting tool base body, after cleaning, performing drying at 150 DEG C for 5min, and placing the dried cutting tool base body into a vacuum chamber, wherein the blasting sand for wet-sand blasting treatment comprises the following components in percentage by mass: 32% of alumina abrasives with particle size of 600 meshes, 2% of an antirust agent and 66% of water; the sand blasting pressure is 0.8 MPa, and the sand blasting time is 15min; the cleaning process for the cutting tool base body is as follows: firstly, cleaning the cutting tool base body with a commercial finished cleaning agent for 8min, and then, cleaning the cutting tool base body with clean water for 8min;
Step 2: performing glow sputter cleaning on the cutting tool base body:
   when the vacuum degree of the vacuum chamber is greater than or equal to 3×10⁻³ Pa, performing warming to 500 DEG C, introducing high-purity Ar gas into the vacuum chamber, adjusting the pressure intensity of the vacuum chamber to 2 Pa, and performing glow sputter cleaning for 30min under the condition that pulsed negative bias is 1000 V and the duty cycle is 20%;
Step 3: preparing the bottom coating:
   under the deposition condition that N₂ gas with flow of 20sccm is introduced into the vacuum chamber, besides the flow of Ar gas is adjusted to 30sccm, the temperature is 500 DEG C, the negative bias is 20V, and the vacuum degree is 0.3 Pa,
   depositing a pure Ti transition layer of which the thickness is 200 nm with a pure titanium target with purity of 99.99%; and
   with the deposition condition unchanged, depositing a bottom coating of which the thickness is 3 micrometers with a titanium-aluminum-tantalum alloy target, wherein the titanium-aluminum-tantalum alloy target comprises the following components in atomic percentage of 20at.% of titanium, 45at.% of aluminum and 35at.% of tantalum;
Step 4: preparing the top coating:
   after preparation of the bottom coating, closing N₂ gas, introducing high-purity O₂ gas with flow of 36sccm into the vacuum chamber, and with vacuum degree and negative bias unchanged, depositing a top coating of which the thickness is 50 nm with a pure tantalum target; and
Step 5: lowering the temperature to 120 DEG C along with the furnace, then taking out the cutting tool, and performing cooling at normal temperature.

The structure of the prepared composite functional cutting tool coating for cutting titanium alloys is shown as fig.1.

### Embodiment 7

A composite functional cutting tool coating for cutting titanium alloys comprises a bottom coating and a top coating, wherein
the bottom coating comprises the following elements in atomic percentage: 40at.% of titanium, 5.12at.% of aluminum, 13.8at.% of tantalum and 41.08at.% of nitrogen, and the thickness is 1[mu]m; and
the top coating comprises the following elements in atomic percentage: 60.40at.% of oxygen, 39.60at.% of tantalum and the thickness is 1500 nm.

A preparation method of the composite functional cutting tool coating for cutting titanium alloys comprises the following steps of
Step 1: performing pretreatment on a cutting tool base body:
   performing wet-sand blasting on the cutting tool base body, after cleaning, performing drying at 150 DEG C for 5min, and placing the dried cutting tool base body into a vacuum chamber, wherein the blasting sand for wet-sand blasting treatment comprises the following components in percentage by mass: 32% of alumina abrasives with particle size of 600 meshes, 2% of an antirust agent and 66% of water; the sand blasting pressure is 0.8 MPa, and the sand blasting time is 10min; the cleaning process for the cutting tool base body is as follows: firstly, cleaning the cutting tool base body with a commercial finished cleaning agent for 10min, and then, cleaning the cutting tool base body with clean water for 10min;
Step 2: performing glow sputter cleaning on the cutting tool base body:
   when the vacuum degree of the vacuum chamber is greater than or equal to 3×10⁻³ Pa, performing warming to 400 DEG C, introducing high-purity Ar gas into the vacuum chamber, adjusting the pressure intensity of the vacuum chamber to 0.5 Pa, and performing glow sputter cleaning for 15min under the condition that pulsed negative bias is 500V and the duty cycle is 80%;
Step 3: preparing the bottom coating:
   under the deposition condition that N₂ gas with flow of 25sccm is introduced into the vacuum chamber, besides the flow of Ar gas is adjusted to 50sccm, the temperature is 400 DEG C, the negative bias is 180 V, and the vacuum degree is 0.6 Pa,
   depositing a pure Ti transition layer of which the thickness is 300 nm with a pure titanium target with purity of 99.99%; and
   with the deposition condition unchanged, depositing a bottom coating of which the thickness is 1 micrometer with a titanium-aluminum-tantalum alloy target, wherein the titanium-aluminum-tantalum alloy target comprises the following components in atomic percentage of 68at.% of titanium, 8at.% of aluminum and 24at.% of tantalum;
Step 4: preparing the top coating:
   after preparation of the bottom coating, closing N₂ gas, introducing high-purity O₂ gas with flow of 40sccm into the vacuum chamber, and with vacuum degree and negative bias unchanged, depositing a top coating of which the thickness is 1500 nm with a pure tantalum target; and
Step 5: lowering the temperature to 120 DEG C along with the furnace, then taking out the cutting tool, and performing cooling at normal temperature.

The structure of the prepared composite functional cutting tool coating for cutting titanium alloys is shown as fig.1.

### Embodiment 8

A composite functional cutting tool coating for cutting titanium alloys comprises a bottom coating and a top coating, wherein
the bottom coating comprises the following elements in atomic percentage: 40at.% of titanium, 5.12at.% of aluminum, 13.8at.% of tantalum and 41.08at.% of nitrogen, and the thickness is 1 micrometer; and the top coating comprises the following elements in atomic percentage: 75.2at.% of oxygen, and 24.8at.% of tantalum, and the thickness is 150 nm.

A preparation method of the composite functional cutting tool coating for cutting titanium alloys comprises the following steps of
Step 1: performing pretreatment on a cutting tool base body:
   performing wet-sand blasting on the cutting tool base body, after cleaning, performing drying at 150 DEG C for 5min, and placing the dried cutting tool base body into a vacuum chamber, wherein blasting sand for wet-sand blasting treatment comprises the following components in percentage by mass: 32% of alumina abrasives with particle size of 600 meshes, 2% of an antirust agent and 66% of water; the sand blasting pressure is 0.8 MPa, and the sand blasting time is 10min; the cleaning process for the cutting tool base body is as follows: firstly, cleaning the cutting tool base body with a commercial finished cleaning agent for 10min, and then, cleaning the cutting tool base body with clean water for 10min;
Step 2: performing glow sputter cleaning on the cutting tool base body:
   when the vacuum degree of the vacuum chamber is greater than or equal to 3×10⁻³ Pa, performing warming to 350 DEG C, introducing high-purity Ar gas into the vacuum chamber, adjusting the pressure intensity of the vacuum chamber to 0.5 Pa, and performing glow sputter cleaning for 15min under the condition that pulsed negative bias is 500V and the duty cycle is 80%;
Step 3: preparing the bottom coating:
   under the deposition condition that N₂ gas with flow of 25sccm is introduced into the vacuum chamber, besides the flow of Ar gas is adjusted to 50sccm, the temperature is 400 DEG C, the negative bias is 180 V, and the vacuum degree is 0.6 Pa,
   depositing a pure Ti transition layer of which the thickness is 300 nm with a pure titanium target with purity of 99.99%; and
   with the deposition condition unchanged, depositing a bottom coating of which the thickness is 1 micrometer by the method of co-sputtering with a titanium-aluminum alloy target and a pure tantalum target, wherein the titanium-aluminum-tantalum alloy target comprises the following components in atomic percentage of 80at.% of titanium, and 20at.% of aluminum;
Step 4: preparing the top coating:
   after preparation of the bottom coating, closing N₂ gas, introducing high-purity O₂ gas with flow of 45sccm into the vacuum chamber, and with vacuum degree and negative bias unchanged, depositing a top coating of which the thickness is 150 nm with a pure tantalum target; and
Step 5: lowering the temperature to 120 DEG C along with the furnace, then taking out the cutting tool, and performing cooling at normal temperature.

The structure of the prepared composite functional cutting tool coating for cutting titanium alloys is shown as fig.1.

### Comparison example 1

The coating adopted in the embodiment is a single-layer TiAlTaN coating which comprises the following elements in atomic percentage: 40at.% of titanium, 5.12at.% of aluminum, 13.8at.% of tantalum and 41.08at.% of nitrogen, and the thickness is 1 micrometer ; a preparation method of the single-layer TiAlTaN coating comprises the step 1, the step 2, the step 3 and the step 5 in the embodiment 8.

### Comparison example 2

The foreign TiAlSiN/TaO composite functional cutting tool coating comprises a bottom coating and a top coating,
wherein the bottom coating is a TiAlSiN coating produced by a certain foreign coating company and comprises the following elements in atomic percentage: 31.02at.% of titanium, 13.66at.% of aluminum, 2.88at.% of silicon and 52.44at.% of nitrogen, and the thickness is 1.8 micrometers ; and the top coating comprises the following elements in atomic percentage: 75.2at.% of oxygen and 24.8at.% of tantalum, and the thickness is 150 nm.

A preparation method of the foreign TiAlSiN/TaO composite functional cutting tool coating comprises the following steps of
Step 1: performing pretreatment on a cutting tool base body:
   performing wet-sand blasting on the cutting tool base body, after cleaning, performing drying at 150 DEG C for 15min, and placing the dried cutting tool base body into a vacuum chamber, wherein blasting sand for wet-sand blasting treatment comprises the following components in percentage by mass: 32% of alumina abrasives with particle size of 600 meshes, 2% of an antirust agent and 66% of water; the sand blasting pressure is 0.5 MPa, and the sand blasting time is 20min; the cleaning process for the cutting tool base body is as follows: firstly, cleaning the cutting tool base body with a commercial finished cleaning agent for 10min, and then, cleaning the cutting tool base body with clean water for 5min;
Step 2: performing glow sputter cleaning on the cutting tool base body:
   when the vacuum degree of the vacuum chamber is greater than or equal to 3×10⁻³ Pa, performing warning to 500 DEG C, introducing high-purity Ar gas into the vacuum chamber, adjusting the pressure intensity of the vacuum chamber to 2 Pa, and performing glow sputter cleaning for 30 min under the condition that pulsed negative bias is 1000 V and the duty cycle is 20%;
Step 3: preparing the bottom coating:
   this step of preparing the bottom coating is entrusted to a foreign coating manufacturer, and the used method is magnetron sputtering; the coating mainly contains four elements of Ti, Al, Si and N, the hardness is 3500 HV, the friction coefficient is 0.4, and the outside color is dark brass;
Step 4: preparing the top coating:
   after preparation of the bottom coating, introducing high-purity O₂ gas with flow of 25sccm and high-purity O₂ gas with flow of 35sccm into the vacuum chamber, and under the condition that the vacuum degree is 0.5 Pa and the negative bias is 180 V, depositing a top coating of which the thickness is 150nm with a pure tantalum target; and
Step 5: lowering the temperature to 120 DEG C along with the furnace, then taking out the cutting tool, and performing cooling at normal temperature.

### Comparison example 3

A single-layer TiAlSiN coating produced by a certain foreign coating company comprises the following elements in atomic percentage: 31.02at.% of titanium, 13.66at.% of aluminum, 2.88at.% of silicon and 52.44at.% of nitrogen, and the thickness is 1.8 micrometer.

A preparation method of the single-layer TiAlSiN coating produced by a certain foreign coating company comprises the step 1, the step 2, the step 3 and the step 5 in the comparison example 2.

The implementation process and pretreatment for a physical vapor deposition method and a chemical vapor deposition method for preparing the composite functional cutting tool coating disclosed by the present invention exist in the prior art and will not be repeated herein. Titanium alloy cutting experiment

### 1. Experiment equipment and materials

An MAZAK200Y5 axis-linkage horizontal turn-milling center is used for conducting titanium alloy TC4 cutting experiment. The spindle maximum speed of the center is 10000 r/min, and the rated power can reach 22.35 kW.

A TC4 bar material used for the experiment is a typical alpha+beta two-phase alloy, the yield strength is 834 MPa, the hardness is 36 HRC, the modulus of elasticity is 114 GPa, and density and thermal conductivity are 4430 kg/m³ and 6.7 w/(m•k) respectively.

Cutting tools used in the experiment are respectively as follows:
a coated cutting tool a is the single-layer TiAlTaN coated cutting tool prepared in the comparison example 1. A YG8 cemented carbide is used as the cutting tool base body (blade model: CNMG120408), after pretreatment on the cutting tool base body, a Ti transition layer and a TiAlTaN coating are successively deposited on the cutting tool base body through a physical vapor deposition technology, and the conditions are the same as the preparation method of the TiAlTaN bottom coating in the step 3 of the embodiment 8;
a coated cutting tool b is the TiAlTaN/TaO composite functional cutting tool coated cutting tool prepared in the comparison example 8. A YG8 cemented carbide is used as the cutting tool base body (blade model: CNMG120408), after pretreatment of the cutting tool base body, a Ti transition layer, a TiAlTaN bottom coating and a TaO functional layer are successively deposited on the cutting tool base body through the physical vapor deposition technology;
a coated cutting tool c is the foreign TiAlSiN coated cutting tool prepared in the comparison example 3. A YG8 cemented carbide is used as the cutting tool base body (blade model: CNMG120408), and the preparation of the TiAlSiN coating is entrusted to a foreign well-known coating manufacturer; and
a coated cutting tool d is the foreign cutting tool with the TiAlSiN/TaO composite functional cutting tool coating prepared in the comparison example 2. A YG8 cemented carbide is used as the cutting tool base body (blade model: CNMG120408), the preparation of the TiAlSiN coating is entrusted to a foreign well-known coating manufacturer, and then a TaO coating continues to be deposited on the TiAlSiN coating through the physical vapor deposition technology.

The Ti transition layer is applied to the surface of the YG8 cutting tool base body, so that the physical and chemical transition match between the coating and the cemented carbide base body is facilitated, and the binding force of the coating is better.

### 2. Experimental procedure

The wet turning method is adopted in the experiment, the cutting speed Vc=100 m/min, the cutting depth ap=0.5 mm, and the feed per revolution fa=0.2 mm/r. When the cutting distance reaches a certain length during cutting, the tool flank wear of the coating is observed through an Olympus light microscope.

### 3. Experimental result and discussion

When the titanium alloy turning speed is 100 m/min, the relationship diagram between the tool flank wear and the cutting length of the cutting tool with the TiAlTaN/TaO composite functional cutting tool coating prepared in the embodiment 8 and the cutting tool with the single-layer TiAlTaN coating prepared in the comparison example 1 is shown in Fig.2, and the cutting length of the cutting tool when the tool flank wear reaches 0.3 mm is taken as the criterion for evaluating the cutting performance of the coated cutting tools. From the figure, it can be seen that when the rear tool flank wear reaches 0.3 mm, the cutting length of the TiAlTaN coated cutting tool is 110 m, while the cutting length of the cutting tool with the TiAlTaN/TaO composite functional coating can be increased to about 340 m. The cutting performance of the composite functional cutting tool coating is increased by more than 3 times, and the cutting performance of the coated cutting tool is obviously improved. Therefore, the prepared composite functional cutting tool coating disclosed by the present invention is favorable for reducing the wear of the cutting tool and prolonging the service life of the cutting tool.

Fig.3 is the wear appearance photos of the cutting tool with the TiAlTaN/TaO composite functional cutting tool coating prepared in the embodiment 8 and the cutting tool with the single-layer TiAlTaN coating prepared in the comparison example 1. From the figure, it can be seen that both of the coated cutting tools have different degrees of sticking and wear. Fig.3 (a) is the wear appearance photo of the cutting tool with the single-layer TiAlTaN coating prepared in the comparison example 1; as shown by the dashed box in Fig.3 (a), a large amount of sticking substances exist at the tip of the TiAlTaN coated cutting tool, and EDX energy spectrum analysis results show that the sticking substances mainly contain Ti, Al, V, W, C, O, and the like, which indicates these sticking substances are caused by chemical reactions and sticking between the cutting tool material and titanium alloy workpieces during cutting. Such sticking substances are also called as built-up edges and will fall off together with part of the cutting tool materials as cutting proceeds, thereby aggravating the wear of the cutting tool, as shown in the location indicated by 5 in the enlarged drawing of the dashed area in Fig.3 (a). Fig.3 (b) is the wear appearance photo of the cutting tool with the TiAlTaN/TaO composite functional cutting tool coating prepared in the embodiment 8; after the cutting tool with the TiAlTaN/TaO composite functional cutting tool coating cuts titanium alloys, few sticking substances exist at the tip, as shown by the dashed box in Fig.3 (b). The EDX energy spectrum analysis result shows that such sticking substance block mainly contains Ti, V, C, O, Al, Fe, W and the like, which indicates the sticking substance is formed after a sticking reaction between the cutting tool material and titanium alloy workpieces. The reason for few sticking substances at the tip of the cutting tool with the TiAlTaN/TaO composite functional cutting tool coating can lie in that an added TaO functional layer reduces sticking and reactions between the coating and titanium alloys, so that workpiece materials are not liable to stick to the tip.

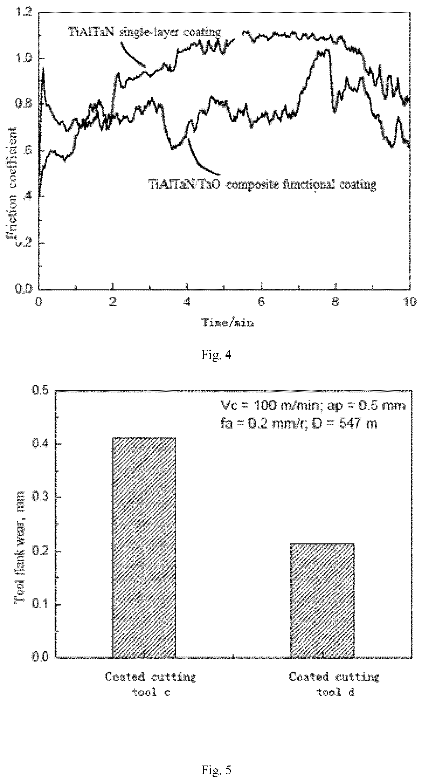

The frictional wear experiment curves of the cutting tool with the TiAlTaN/TaO composite functional cutting tool coating prepared in the embodiment 8 and the cutting tool with the single-layer TiAlTaN coating prepared in the comparison example 1 are shown in Fig.4, wherein the friction coefficient of the TiAlTaN/TaO composite functional cutting tool coating is lower than that of the single-layer TiAlTaN coating, so that it is not liable to form large sticking substances at the tip.

Through tests, the above surface oxide functional coating can also be applied onto other conventional cutting tool coatings, including but not limited to TiAlN, TiAlSiN, CrAlN and the like. The surface functional coating disclosed by the present invention has expandability, can also reduce the wear of the cutting tools and can prolong the service life of the cutting tools during cutting of titanium alloys when being applied to other conventional coatings.

Under the same conditions that the cutting speed is Vc=100 m/min, the cutting depth is ap=0.5 mm and the feed per revolution is fa=0.2 mm/r, after cutting for 547 m, the rear tool flank wear bar charts of the cutting tool with the TiAlSiN/TaO composite functional cutting tool coating prepared in the comparison example 2 and the cutting tool with the TiAlSiN coating prepared in the comparison example 3 are shown as Fig.5. From the figure, it can be seen that the wear of a foreign TiAlSiN coated cutting tool with the TaO surface functional layer is only half of that of the ordinary foreign TiAlSiN coated cutting tool, and the titanium alloy cutting performance of the cutting tool with the composite functional cutting tool coating is improved by about two times. It means that the surface oxide functional coating can also have good cutting effects and reduce the wear of coated cutting tools when being applied to other conventional cutting tool coatings.

## Claims

1. A composite functional cutting tool coating for cutting titanium alloys, **characterized by** comprising a bottom coating and a top coating, wherein
the bottom coating consists of the following elements in atomic percentage: 10-40at.% of titanium, 5-20at.% of aluminum, 2-18at.% of tantalum and 40.16-55at.% of nitrogen, and the thickness is 1 to 4 micrometers ; and the top coating consists of the following elements in atomic percentage: 50-78.02at.% of oxygen, 8-35at.% of tantalum and the thickness is 50-1,500 nm.

2. A preparation method of the composite functional cutting tool coating for cutting titanium alloys of claim 1, **characterized by** comprising the following steps of
Step 1: performing pretreatment on a cutting tool base body:
performing wet-sand blasting on the cutting tool base body, performing cleaning, performing drying at 80-150 DEG C for 5-15 min, and placing the dried cutting tool base body into a vacuum chamber;
Step 2: performing glow sputter cleaning on the cutting tool base body:
when the vacuum degree of the vacuum chamber is better than or equal to 3×10⁻³ Pa, performing warming to 350-500 DEG C, introducing high-purity Ar gas into the vacuum chamber, adjusting the pressure intensity of the vacuum chamber to 0.5-2 Pa, and performing glow sputter cleaning for 15-30 min under the condition that pulsed negative bias is 500-1,000 V and the duty cycle is 20-80%;
Step 3: preparing the bottom coating:
under the deposition condition that N₂ gas with flow of 20-50sccm is introduced into the vacuum chamber, besides the flow of Ar gas is adjusted to 30-50sccm, the temperature is 400-500 DEG C, the negative bias is 20-180 V, and the vacuum degree is 0.3-0.9 Pa,
depositing a pure Ti transition layer of which the thickness is 150-300 nm with a pure titanium target with purity of 99.99%;
with the deposition condition unchanged, preparing the bottom coating by the method (1) or method (2):
(1) depositing a bottom coating of which the thickness is 1 to 4 micrometers with a titanium-aluminum-tantalum alloy target; or
(2) preparing a bottom coating of which the thickness is 1 to 4 micrometers by the method of co-sputtering with a titanium-aluminum alloy target and a pure tantalum target;
Step 4: preparing the top coating:
after preparation of the bottom coating, closing N₂ gas, introducing high-purity O₂ gas with flow of 15-50sccm into the vacuum chamber, and with vacuum degree and negative bias unchanged, depositing a top coating of which the thickness is 50-1500 nm with a pure tantalum target; and
Step 5: after lowering the temperature to 120 DEG C along with the furnace, taking out the cutting tool, and performing cooling at normal temperature.

3. The preparation method of the composite functional cutting tool coating for cutting titanium alloys of claim 2, **characterized in that**: in the step 1, blasting sand for wet-sand blasting treatment comprises the following components in percentage by mass: 20-35% of alumina abrasives with particle size of 400-600 meshes, 1-15% of an antirust agent and 50-79% of water; the sand blasting pressure is 0.5-0.8 MPa, and the sand blasting time is 10-20 min; and the cleaning process for the cutting tool base body is as follows: firstly, cleaning the cutting tool base body with a commercial finished cleaning agent for 5 min or above, and then, cleaning the cutting tool base body with clean water for 5 min or above.

4. The preparation method of the composite functional cutting tool coating for cutting titanium alloys of claim 2, **characterized in that**: in the method (1) of the step 3, the titanium-aluminum-tantalum alloy target comprises the following components in atomic percentage: 20-70at.% of titanium, 5-50at.% of aluminum and 5-35at.% of tantalum; in the method (2) of the step 3, the titanium-aluminum alloy target comprises the following components in atomic percentage: 20-80at.% of titanium and 20-80at.% of aluminum.

## Patentansprüche

1. Funktionale Kompositschneider-Beschichtung zum Schneiden von Titanlegierungen, **dadurch gekennzeichnet, dass** es eine untere Beschichtung und eine obere Beschichtung umfasst, wobei
die untere Beschichtung aus den folgenden Elementen in Molprozent gebildet: 10-40 Mol-% Titan, 5-20 Mol-% Aluminium, 2-18 Mol-% Tantal und 40,16-55 Mol-% Stickstoff und die Dicke 1 bis 4 Mikrometer beträgt; und die obere Schicht aus den folgenden Elementen in Molprozent gebildet ist: 50-78,02 Mol-% Sauerstoff, 8-35 Mol-% Tantal und die Dicke 50-1.500 nm beträgt.

2. Zubereitungsverfahren der funktionalen Kompositschneider-Beschichtung zum Schneiden von Titanlegierungen gemäß Anspruch 1, **dadurch gekennzeichnet, dass** es die folgenden Schritte umfasst
Schritt 1: Durchführen der Vorbehandlung auf einem Schneider-Basiskörper;
Durchführen des Sandblasens auf dem Schneider-Basiskörper, Durchführen des Reinigens, Durchführen des Trocknens bei 80-150 GRAD C über 5-15 Min. und Anordnen des getrockneten Schneider-Basiskörpers in einer Vakuumkammer;
Schritt 2: Durchführen einer Glühzündungsreinigung auf dem Schneider-Basiskörper;
wenn der Vakuumgrad der Vakuumkammer besser als oder gleich 3 x 10⁻³ Pa ist, Durchführen des Erwärmens auf 350-500 GRAD C, Einführen eines hochreinen Ar-Gases in die Vakuumkammer, Anpassen der Druckintensität der Vakuumkammer auf 0,5-2 Pa und Durchführen der Glühzündungsreinigung über 15-30 Min. unter der Bedingung, dass die gepulste negative Verzerrung 500-1.000 V beträgt und der Arbeitszyklus 20-80 % beträgt;
Schritt 3: Zubereitung der unteren Beschichtung:
unter der Aufbringungsbedingung, dass N₂-Gas mit einem Durchsatz von 20-50 sccm in die Vakuumkammer eingeführt ist, weiterhin ist der Strom des Ar-Gases auf 30-50 sccm angepasst, die Temperatur beträgt 400-500 GRAD C, die negative Verzerrung beträgt 20-180 V und der Vakuumgrad beträgt 0,3-0,9 Pa,
Aufbringen einer reinen Ti-Übergangsschicht, deren Dicke 150-300 nm mit einem reinen Titanziel mit einer Reinheit von 99,99 % beträgt;
wenn die Aufbringungsbedingung unverändert ist, Zubereiten der unteren Beschichtung durch das Verfahren (1) oder das Verfahren (2);
(1) Aufbringen einer unteren Beschichtung, deren Dicke 1 bis 4 Mikrometer mit einem Titan-Aluminium-Tantallegierungsziel beträgt; oder
(2) Zubereiten einer unteren Beschichtung, deren Dicke 1 bis 4 Mikrometer beträgt, durch das Verfahren des Co-Sputterns mit einem Titan-Aluminium-Legierungsziel und einem reinen Tantalziel;
Schritt 4: Zubereiten der oberen Beschichtung;
nach dem Zubereiten der unteren Beschichtung, Schließen des N₂-Gases, Einführen von hochreinem O₂-Gas mit einem Durchsatz von 15-50 sccm in die Vakuumkammer und mit unverändertem Vakuumgrad und negativer Verzerrung Aufbringen einer oberen Beschichtung, deren Dicke 50-1500 nm beträgt, mit einem reinen Tantalziel; und
Schritt 5: nach dem Senken der Temperatur auf 120 GRAD D zusammen mit dem Ofen Entnehmen des Schneiders und Durchführen der Abkühlung auf Normaltemperatur.

3. Zubereitungsverfahren der funktionalen Kompositschneider-Beschichtung zum Schneiden von Titanlegierungen gemäß Anspruch 2, **dadurch gekennzeichnet, dass**: in Schritt 1 das Sandblasen für eine feuchte Sandblas-Behandlung die folgenden Bestandteile in Masseprozent umfasst: 20-35 % Aluminiumabrieb mit Partikelgrößen von 400-600 Mesh, 1-15 % eines Rostschutzmittels und 50-79 % Wasser, der Sandblasdruck beträgt 0,5-0,8 MPa und die Sandblaszeit beträgt 10-20 Min.; und der Reinigungsprozess für den Schneid-Basiskörper ist wie folgt: zuerst Reinigen des Schneid-Basiskörpers mit einem handelsüblichen entwickelten Reinigungsmittel über 5 Min. oder länger und dann Reinigen des Schneider-Basiskörpers mit sauberem Wassers über 5 Min. oder länger.

4. Zubereitungsverfahren der funktionalen Kompositschneider-Beschichtung zum Schneiden von Titanlegierungen gemäß Anspruch 2, **dadurch gekennzeichnet, dass**: bei dem Verfahren (1) des Schritts 3 das Titan-Aluminium-Tantallegierungsziel die folgenden Bestandteile in Molprozent umfasst: 20-70 Mol-% Titan, 5-50 Mol-% Aluminium und 5-35 Mol-Prozent Tantal; bei dem Verfahren (2) des Schritts 3 das Titan-Aluminium-Legierungsziel die folgenden Bestandteile in Mol-Prozent umfasst: 20-80 Mol-% Titan und 20-80 Mol-% Aluminium.

## Revendications

1. Un revêtement composite d'outil de coupe fonctionnel pour couper des alliages de titane, **caractérisé par le fait qu'**il comprend un revêtement de fond et un revêtement de surface, dans lequel
le revêtement de fond se compose des éléments suivants en pourcentage atomique : 10-40 at.% de titane, 5-20at.% d'aluminium, 2-18at.% de tantale et 40.16-55at.% d'azote, et l'épaisseur est de 1-4 [mu]m ; et
le revêtement de surface se compose des éléments suivants en pourcentage atomique : 50-78.02at.% d'oxygène, 8-35at.% de tantale and l'épaisseur est de 50-1.500 nm.

2. Méthode de préparation du revêtement composite de l'outil de coupe fonctionnel pour couper les alliages de titane de la revendication 1, comprenant les étapes de :
Étape 1 : on effectue un prétraitement sur le corps de base d'un outil de coupe :
on sable avec un sable humide le corps de base de l'outil de coupe, on effectue le nettoyage, on effectue le séchage à 80-150 DEG C pendant 5-15 min, et on place le corps de base de l'outil de coupe séché dans une chambre à vide ;
Étape 2 : on effectue un nettoyage à décharge luminescente sur le corps de base de l'outil de coupe
lorsque le degré de vide de la chambre à vide est plus grand ou égal à 3×10⁻³ Pa, on effectue le réchauffement à 350-500 DEG C, on introduit le gaz Ar de haute pureté dans la chambre à vide, on ajuste l'intensité de pression de la chambre à vide à 0,5-2 Pa, et on effectue le nettoyage à décharge luminescente pendant 15-30 min à la condition que le biais négatif pulsé est de 500-1000 V et le cycle de service est de 20-80% ;
Étape 3 : préparation du revêtement de fond
Sous les conditions de dépôt que le gaz N₂ est introduit dans la chambre à vide avec un débit de 20-50sccm, que l'écoulement du gaz Ar est ajusté à 30-50sccm, que la température est de 400-500 DEG C, que le biais négatif est de 20-180 V et que le degré de vide est de 0,3-0,9 Pa,
on dépose une couche de transition de Ti pure dont l'épaisseur est de 150-300 nm dont la pureté cible du Ti est de 99,99%;
sans modifier les conditions de dépôt, on prépare le revêtement de fond par la méthode (1) ou la méthode (2):
( 1) on dépose un revêtement de fond dont l'épaisseur est de 1-4[mu]m avec un alliage titane-aluminium-tantale de teneur ciblé ; ou
( 2) on prépare un revêtement de fond dont l'épaisseur est de 1-4[mu]m par la méthode de co-pulvérisation avec un alliage titane-aluminium et de tantale pur de teneur ciblée ;
Étape 4 : on prépare le revêtement de surface :
après la préparation du revêtement de fond, on ferme le gaz N₂, on introduit le gaz O₂ de haute pureté avec un débit de 15-50sccm dans la chambre à vide, et avec un degré de vide et un biais négatif inchangé, on dépose un revêtement de surface dont l'épaisseur est de 50-1500 nm avec du tantale pur en teneur ciblé; et
Étape 5 : après avoir abaissé la température à 120 DEG C avec le four, on prend l'outil de coupe et on effectue le refroidissement à température normale.

3. La méthode de préparation du revêtement composite d'outil de coupe fonctionnel pour couper des alliages de titane de la revendication 2, **caractérisé par le fait que** : dans l'étape 1, le sable du sablage humide comprend les composants suivants en pourcentage par masse: 20-35% des abrasifs d'alumine avec une taille des particules de 400-600 mailles, 1-15% d'un agent antirustique et 50-79% d'eau; la pression de sablage de 0,5-0,8 MPa, et le temps de sablage est de 10-20 min; et le processus de nettoyage pour le corps de base de l'outil de coupe est le suivant: tout d'abord, on nettoie le corps de base de l'outil de coupe avec un agent de nettoyage commercial pendant 5 min ou plus, puis, on nettoie le corps de base de l'outil de coupe avec de l'eau propre pendant 5 min ou plus.

4. La méthode de préparation du revêtement composite de l'outil de coupe fonctionnel pour couper des alliages de titane de la revendication 2, **caractérisée par le fait que** : dans la méthode (1) de l'étape 3, l'alliage titane-aluminium-tantale de teneur ciblée comprend les composants suivants en pourcentage atomique: 20-70at.% de titane, 5-50at.% d'aluminium et 5-35at.% de tantale; dans la méthode (2) de l'étape 3, l'alliage titane-aluminium de teneur ciblée comprend les composants suivants en pourcentage atomique 20-80at.% de titane et 20-80at.% d'aluminium.
